# EUROPEAN PATENT APPLICATION

(11) **EP 3 712 961 A1**
(43) Date of publication of application: **23.09.2020**
(21) Application number: 19164621.5
(22) Date of filing: 22.03.2019
(51) Int. Cl.: H01L 29/861, H01L 29/40

(54) **REVERSE CONDUCTING INSULATED GATE POWER SEMICONDUCTOR DEVICE HAVING LOW CONDUCTION LOSSES**

(71) Applicant: ABB Schweiz AG, 5400 Baden (CH)
(72) Inventor: PAPADOPOULOS, Charalampos, 5600 Lenzburg (CH); CORVASCE, Chiara, 8962 Bergdietikon (CH); BOKSTEEN, Boni, 5600 Lenzburg (CH); DE-MICHIELIS, Luca, 5000 Aarau (CH)
(74) Representative: Kuhnen & Wacker Patent- und Rechtsanwaltsbüro PartG mbB

(57) **Abstract**

A reverse conducting insulated gate power semiconductor device an active unit cell adjacent to the first main side, and a pilot diode region comprising a second conductivity type anode layer. The anode layer comprises plural anode regions which are separated from each other and alternate in a lateral first direction parallel to the first main side with trench-type first gate electrodes that are respectively separated from the anode layer. Each anode region is in direct contact with the first main electrode and is in direct contact with a first conductivity type base layer. The active unit cell comprises a first conductivity type first source layer, a second conductivity type base layer and a second gate electrode which form a first field effect transistor structure. The first gate electrodes are electrically insulated from the first main electrode and from the second gate electrode such that the first gate electrodes are configured to be controlled independently from the second gate electrode and the first main electrode.

## Description

### Field of the invention

The invention relates to the field of power electronics, and more particularly to a reverse conducting insulated gate power semiconductor device according to the preamble of claim 1.

### Background of the invention

A reverse conducting (RC) insulated gate power semiconductor device well known in the prior art is the reverse conducting insulated gate bipolar transistor (RC-IGBT). In the RC-IGBT a diode and an IGBT are monolithically integrated on the same wafer or chip by introducing n⁺ doped collector shorts in a part of the p⁺ doped collector layer of an IGBT structure. The RC-IGBT can be either a planar RC-IGBT with a planar MOSFET structure on its emitter side or a trench RC-IGBT with trench MOSFET structure on the emitter side of the device.

In the publication "The Bi-mode Insulated Gate Transistor (BiGT) A potential technology for higher power applications" by M. Rahimo et al. (in Proc. Int. Sym. on Power Semiconductor Devices & IC's ISPSD '09, Barcelona, Spain, 2009, pp. 283-286) there is disclosed an advanced RC-IGBT concept referred to as the Bi-mode Insulated Gate Transistor (BIGT). The BIGT is aimed at overcoming certain constraints of the common RC-IGBT for high voltages and hard switching applications. Specifically, one of the implications of anode shorting in the RC-IGBT is the voltage snapback effect which is observed as a negative resistance region in the device IGBT mode I-V characteristics. Such voltage snapback effect has a particular negative impact when devices are paralleled, especially at low temperatures. The BIGT is basically a hybrid structure consisting of an RC-IGBT and a standard IGBT (also referred to as pilot IGBT) in a single chip.

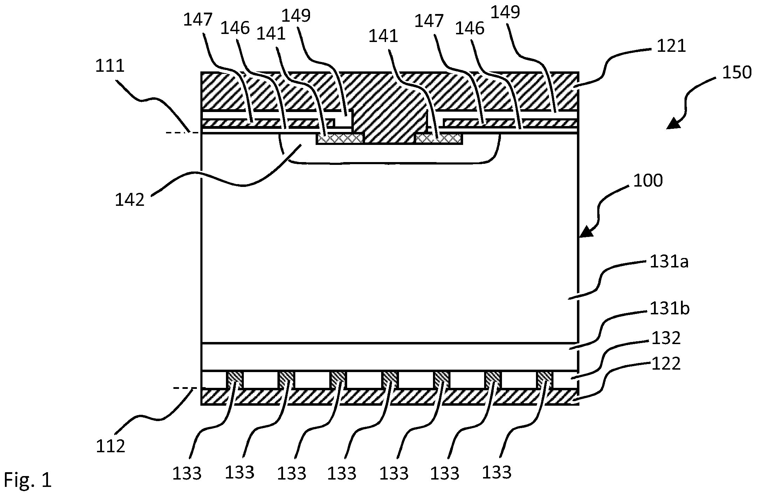

Fig. 1 shows a prior art RC-IGBT 150 with a planar gate electrode 147 according to a known implementation. As shown in FIG. 1, the RC-IGBT 150 includes within one wafer 100 an insulated gate bipolar transistor (IGBT) with a built-in freewheeling diode. More specifically, the wafer 100 has a first main side 111, which is the emitter side of the integrated IGBT and the anode side of the built-in freewheeling diode, and a second main side 112, which is the collector side of the IGBT and the cathode side of the built-in freewheeling diode. The second main side 112 lies opposite the first main side 111. An n-type drift layer 131a is arranged between the first main side 111 and the second main side 112, and a p-type base layer 142 is arranged as a well region in the drift layer 131a at the first main side 111 of the wafer 100. Also, n-type source regions 141 with a higher doping than the drift layer 131a are formed as well regions in the p-type base layer 142 at the first main side 111 of the wafer 100.

An electrically insulating gate insulating layer 146 is arranged on the first main side 111 and covers part of the p-type base layer 142, the drift layer 131a and the source regions 141. The planar gate electrode 147 is formed on the gate insulating layer 146 to form a MOS structure with the gate insulating layer 146 and the p-type base layer 142 below. A first main electrode 121 is arranged on the first main side 111 to be in direct electrical contact to the source regions 141 and to the p-type base layer 142, whereas it is electrically insulated from the planar gate electrode 147 by another insulating layer 149 covering the planar gate electrode 147.

An n-type buffer layer 131b is arranged on the drift layer 131a at the second main side 112, and a p-type collector layer 132 is arranged on a side of the buffer layer 131b which is opposite the drift layer 131a. Plural n-type collector shorts 133 are arranged to penetrate through the collector layer 132 to electrically connect the buffer layer 131b to a second main electrode 122, which is arranged on the second main side 112 to be in direct electrical contact to the collector layer 132 and to the collector shorts 133. The collector shorts 133 and the buffer layer 131b have a higher doping concentration than the drift layer 131a.

The collector shorts 133, the buffer layer 131b, the drift layer 131a and the p-type base layer 142 form the built-in freewheeling diode with a pin structure between the second main electrode 122, which forms a cathode electrode of the built-in freewheeling diode, and the first main electrode 121, which forms an anode electrode of the built-in freewheeling diode.

In such prior art RC-IGBT 150 the p-type base layer 142 of the IGBT cell is utilized as an anode of the built-in freewheeling diode when the device is in the diode mode. However, the p-type base layer 142 is in contact with the n-type source regions 141 which in turn might be connected with the drift layer 131a via an n-type conductive channel that is formed in the base layer 142 below the gate electrode 147 if the gate emitter voltage V_{GE} exceeds a threshold value. The conductive channel short-circuits the pn junction between the p-type base layer 142 and the drift layer 131a. As a result, the pn junction between the p-type base layer 142 and the drift layer 131a may not be forward biased and hole injection from the base layer 142 into the drift layer 131a may be prevented. A current is maintained by the unipolar electron current flowing through the conductive channel. The pn junction between the base layer 142 and the drift layer 131a starts injecting holes eventually when the potential difference reaches the built in voltage of the pn junction. However, the voltage at the contacts could be much higher. When the hole injection starts, the conductivity of the drift layer 131a is modulated and the voltage drop is reduced. Therefore, depending on the gate emitter voltage, the diode exhibits a characteristic MOS controlled negative resistance region (voltage snap-back) in the I-V characteristics. With the gate emitter voltage above the threshold value, the snap back is the largest, while with the gate emitter voltage below the threshold or negative, no conductive channel is formed and the snap-back is absent completely. In addition, the conductive channel is controlling the plasma concentration below the p-type base layer 142 during the internal diode conduction. By applying a gate emitter voltage above the threshold value, the plasma is extracted through the induced channel, therefore reducing the plasma below the p-type base layer 142, which results in higher on-state losses compared to the situation when the gate emitter voltage is below the threshold value. In various applications gate control during the diode mode cannot be chosen freely, so the device should be able to provide good performance also at positive gate emitter voltages applied to the gate electrode.

In US 2013/099279 A1 there is described a planar RC-IGBT in which additional p-type wells are arranged in the same plane as the base layer but outside the active cells. The p-type wells are electrically connected to the emitter electrode directly or via the base layer. The diode formed by the p-type wells outside the active cells are sometimes also referred to as pilot diodes and the regions in which the p-type wells are arranged may be referred to as pilot diode regions. The pilot diode regions provide improved injection levels and lowered conduction losses in diode mode (reverse conducting state) of the RC-IGBT at any gate emitter voltage applied to the gate electrode. However, in IGBT mode (forward conducting state) of the RC-IGBT the pilot diode regions result in significantly higher IGBT on-state losses due to outflow of holes from the drift layer into the p-type wells resulting in a lowered plasma density in the drift layer and thereby in a higher resistance of the drift layer.

In a trench-type RC-IGBT the conduction losses in diode mode (i.e. reverse conducting mode) may be even higher than in a planar RC-IGBT when a positive gate emitter voltage is applied to the trench-type gate electrode because injection level of holes from the p-type base layer into the drift layer may be lowered even more efficiently by the conductive channel along the trench-type gate electrode due to a stronger shorting effect.

From US 2014/070270 A1, US 2016/0093725 A1 or US 2015/0236143 A1 there is respectively known a trench-type RC-IGBT in which pilot diode regions are arranged outside of active cells to reduce the conduction losses in the diode mode. The pilot diode regions comprise p-type layers which are connected to the emitter electrode and which are laterally sandwiched between two neighbouring trench-type gate electrodes similar to the p-type base layer in the active cells. However, as in the planar RC-IGBT known from US 2013/099279 A1, which employs pilot diode regions, the conduction losses in the IGBT mode (i.e. in forward on-state) of the RC-IGBT are relatively high.

### Summary of the invention

It is an object of the invention to provide a reverse conducting insulated gate power semiconductor device which has an improved trade-off between the conduction losses in diode and IGBT mode, i.e. in reverse and forward conducting mode. The object of the invention is attained by a reverse conducting insulated gate power semiconductor device according to claim 1. Further developments of the invention are specified in the dependent claims.

The reverse conducting insulated gate power semiconductor device according to claim 1 comprises a wafer having a first main side and a second main side opposite to the first main side. A first main electrode is arranged on the first main side and a second main electrode is arranged on the second main side. The wafer comprises a first conductivity type base layer, a second conductivity type collector layer which is in direct contact with the first conductivity type base layer to form a first pn junction and which is in direct contact with the second main electrode, at least one collector short which electrically connects the first conductivity type base layer to the second main electrode, an active unit cell adjacent to the first main side, and a pilot diode region comprising a second conductivity type anode layer extending from the first main side to a first depth. Therein, the first conductivity type is different from the second conductivity type. The anode layer comprises plural anode regions which are separated from each other and alternate in a lateral first direction parallel to the first main side with trench-type first gate electrodes that are respectively separated from the anode layer and from the first conductivity type base layer by a first gate insulating layer. Each anode region is in direct contact with the first main electrode and is in direct contact with the first conductivity type base layer to form a second pn junction. The active unit cell comprises a first conductivity type first source layer, which is in direct contact with the first main electrode on the first main side, a second conductivity type base layer on a side of the first conductivity type base layer opposite to the collector layer and a second gate electrode. The first conductivity type base layer is in direct contact with the second conductivity type base layer to form a third pn junction and the second conductivity type base layer is in direct contact with the first source layer to form a fourth pn junction. The second gate electrode is separated from the first source layer, the second conductivity type base layer and the first conductivity type base layer by a second gate insulating layer to form a first field effect transistor structure. The first gate electrodes are electrically insulated from the first main electrode and from the second gate electrode such that the first gate electrodes are configured to be controlled independently from the second gate electrode and the first main electrode.

The new pilot diode concept provides improved trade-off between the diode and IGBT modes conduction losses. A control of a gate emitter voltage (i.e. the control of an electric potential of the gate electrode relative to the electric potential at the first main electrode as an electric reference potential) applied to the first gate electrodes is most efficient to control the hole concentration in the pilot diode region and to thereby control losses of the device in forward and reverse conduction state. E.g. by applying a positive gate emitter voltage to the first gate electrodes (i.e. a positive electric potential relative to the electric potential of the first main electrode), holes are repelled from the first gate electrodes to lower the hole concentration in the pilot diode region on the emitter side of the first conductivity type base layer. This results in low forward conduction losses (i.e. low losses in the IGBT mode of the device) because the pilot diode region acts efficiently as a PIN effect area. On the other side, by applying a negative gate emitter voltage to the first gate electrodes (i.e. a negative electric potential relative to the electric potential of the first main electrode), holes are attracted by the first gate electrodes resulting in relatively high concentration of holes in the pilot diode region on the emitter side of the first conductivity type base layer. This results in low reverse conduction losses (i.e. low losses in the diode mode of the device). Accordingly, the reverse conducting insulated gate power semiconductor device allows an improved trade-off between the conduction losses in diode and IGBT mode. Moreover, switching or turn-off losses may be lowered by appropriate changes of the gate emitter voltage before any switching and/or turn-off event.

In an exemplary embodiment a lateral size of each anode region in an orthogonal projection onto a vertical plane perpendicular to the first main side and parallel to the lateral first direction is equal to or less than 2 µm, exemplarily equal to or less than 1 µm. This will result in a high level of hole injection in diode mode and a much lower hole drainage level in IGBT mode compared to the known reverse conducting insulated gate power semiconductor devices. In particular, the anode emitter efficiency can be influenced most efficiently by the control of a gate emitter voltage applied to the first gate electrodes in the exemplary embodiment.

In an exemplary embodiment a distance between each pair of neighbouring anode regions is equal to or less than 2 µm, exemplarily equal to or less than 1 µm. In this exemplary embodiment the distance between neighbouring first gate electrodes in the pilot diode region is relatively low resulting in a more efficient control of the hole concentration in the pilot diode region.

In an exemplary embodiment each first gate electrode extends from the first main side to a second depth which is greater than the first depth of the anode layer. In such exemplary embodiment the hole drainage level in IGBT mode is lowered and control of the hole concentration in the pilot diode region is most efficient.

In an exemplary embodiment a lateral distance between the second conductivity type base layer of the active unit cell and the anode layer is at least 15 µm. In such exemplary embodiment cross-effecting between the active unit cell and the pilot diode region is avoided most efficiently resulting in a further improved trade-off between the conduction losses in diode and IGBT mode.

In an exemplary embodiment the first gate electrodes are all electrically connected in common to a diode gate terminal. This facilitates controlling all first gate electrodes simultaneously.

In an exemplary embodiment the first field effect transistor structure of the active unit cell is a trench-type field effect transistor structure in which the second gate electrode is structured as a trench-type gate electrode that extends from the first main side towards the second main side. Accordingly, in this exemplary embodiment the reverse conducting insulated gate power semiconductor device is a trench-type device, which allows most efficient use of the wafer area for high power and/or voltage applications. A trench-type gate electrode shall be understood throughout the specification as a gate electrode which extends from the first main side into the wafer in a direction towards the second main side wherein the second conductivity type base layer is arranged on a lateral side of the trench-type gate electrode, whereas a planar gate electrode shall be understood throughout the specification as a gate electrode which extends on the first main side wherein the second conductivity type base layer is arranged on a side of the planar gate electrode facing in a direction perpendicular to the first main side towards the second main side.

In an exemplary embodiment the second gate electrode of the active unit cell is laterally arranged between the anode layer and the second conductivity type base layer of the active unit cell. In such exemplary embodiment cross-effecting between the active unit cell and the pilot diode region is avoided most efficiently resulting in a further improved trade-off between the conduction losses in diode and IGBT mode.

In an exemplary embodiment the active unit cell comprises a first conductivity type second source layer, which is in direct contact with the first main electrode on the first main side and which is in direct contact with the second conductivity type base layer to form a fifth pn junction, and a third gate electrode, which is separated from the second source layer, the second conductivity type base layer and the first conductivity type base layer by a third gate insulating layer to form a second field effect transistor structure in the active unit cell, wherein the second and the third gate electrodes of the active unit cell are trench-type gate electrodes between which the second conductivity type base layer and the first and second source layers are laterally interposed.

In an exemplary embodiment the reverse conducting insulated gate power semiconductor device is a reverse conducting insulated gate bipolar transistor or a bi-mode insulated gate transistor, in which the an IGBT and an RC-IGBT are integrated in a single wafer, i.e. the collector layer comprises areas with collector shorts and wide areas without collector shorts (exemplarily the wide areas without collector shorts have a width in any lateral direction which is at least three times the average distance between each pair of directly adjacent collector shorts, wherein a first collector short shall be directly adjacent to a second collector short if no other collector short is closer to the second collector short than the first collector short. The term bi-mode implies that the device can operate at the same current densities in transistor (IGBT) mode and freewheeling diode mode by utilizing the same available silicon volume in both operational modes.

In an exemplary embodiment the first gate electrodes respectively have in an orthogonal projection onto a plane parallel to the first main side a stripe-shape, a longitudinal main axis of the stripe-shape extending perpendicular to the lateral first direction. Throughout this specification, a stripe-shape may be any planar shape in which the width in a first direction is at least twice the width in a second direction perpendicular to the first direction.

In an exemplary embodiment one of the first gate electrodes is laterally arranged between the anode layer and the second gate electrode. In such exemplary embodiment cross-effecting between the active unit cell and the pilot diode region is avoided most efficiently resulting in a further improved trade-off between the conduction losses in diode and IGBT mode.

A system comprises the reverse conducting insulated gate power semiconductor device of the invention and a control unit, wherein the control unit is configured to control a diode gate emitter voltage which is defined as the electric potential of the first gate electrodes minus an electric potential of the first main electrode:
- to be positive during a time period in which the reverse conducting insulated gate power semiconductor device is in a forward conducting on-state, and
- to be negative during a time period in which the reverse conducting insulated gate power semiconductor device is in a reverse conducting state.

In such system the control unit allows to efficiently reduce the losses in both, in the IGBT mode and in the diode mode.

In an exemplary embodiment the control unit is configured to switch the diode gate emitter voltage from a first positive value to a second negative value at least 10 µs before a turn-off event changing the reverse conducting insulated gate power semiconductor device from a forward conducting on-state to a blocking state. In such exemplary system the time required for turn-off and switching losses during turn-off of the IGBT integrated in the RC-IGBT in the forward conducting mode are lowered.

In an exemplary embodiment the control unit is configured to switch the diode gate emitter voltage from a third negative value to the fourth positive value at least 10 µs before a turn-off event changing the reverse conducting insulated gate power semiconductor device from a reverse conducting state to a blocking state. In such exemplary system the time required for turn-off and switching losses during turn-off of the freewheeling diode integrated in the RC-IGBT in the reverse conducting mode are lowered.

### Brief Description of Drawings

The subject matter of the invention will become apparent for the skilled person from the following detailed description of embodiments with reference to the attached drawings, in which:
- FIG. 1: shows a prior art planar RC-IGBT in a vertical cross-section;
- FIG. 2: shows a reverse conducting insulated gate power semiconductor device according to a first embodiment in a vertical cross-section along line I-I' in Fig. 3;
- FIG. 3: shows the reverse conducting insulated gate power semiconductor device of Fig. 2 in top view;
- FIG. 4: shows a reverse conducting insulated gate power semiconductor device according to a second embodiment in a vertical cross-section along line II-II' in Fig. 5;
- FIG. 5: shows the reverse conducting insulated gate power semiconductor device of Fig. 4 in top view;
- FIG. 6: shows a reverse conducting insulated gate power semiconductor device according to a third embodiment in top view.
- FIG. 7: shows a comparison of diode on-state during a switching event on a main gate terminal in the reverse conducting insulated gate power semiconductor device of Fig. 4 for two different diode gate emitter voltages applied to a diode gate terminal;
- Fig. 8: shows a graph illustrating collector current versus collector emitter voltage in a reverse conducting insulated gate power semiconductor device of Fig. 4 in forward conducting on-state for two different diode gate emitter voltages applied to a diode gate terminal; and
- Fig. 9: shows a graph illustrating collector current versus collector emitter voltage in a reverse conducting insulated gate power semiconductor device of Fig. 4 in reverse conducting state for two different diode gate emitter voltages applied to a diode gate terminal.

The reference symbols used in the figures and their meanings are summarized in the list of reference symbols. Generally, alike or alike-functioning parts are given the same reference symbols. The described embodiments are meant as examples and shall not limit the scope of the invention as defined by the appended claims.

### Detailed Description of exemplary embodiments

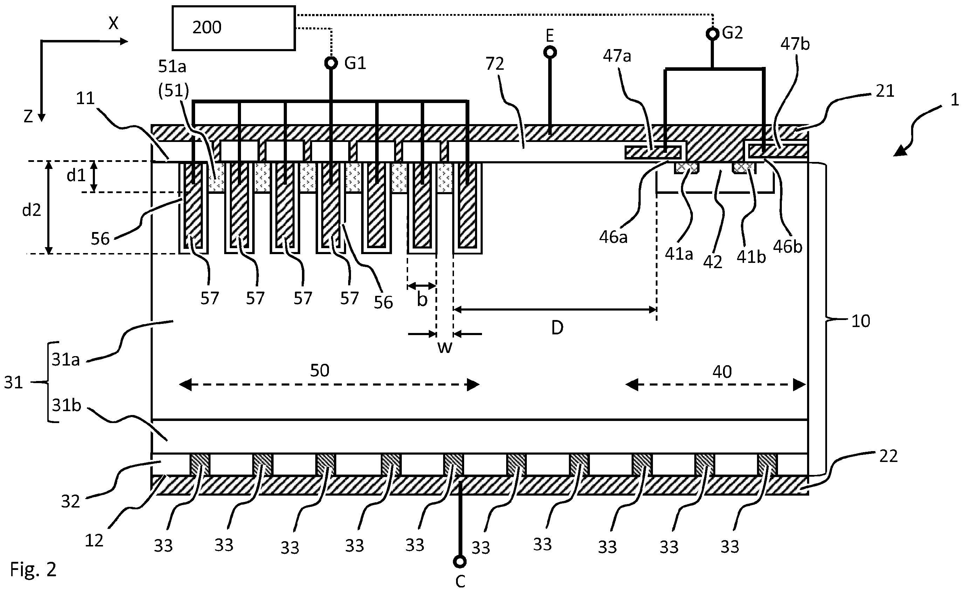

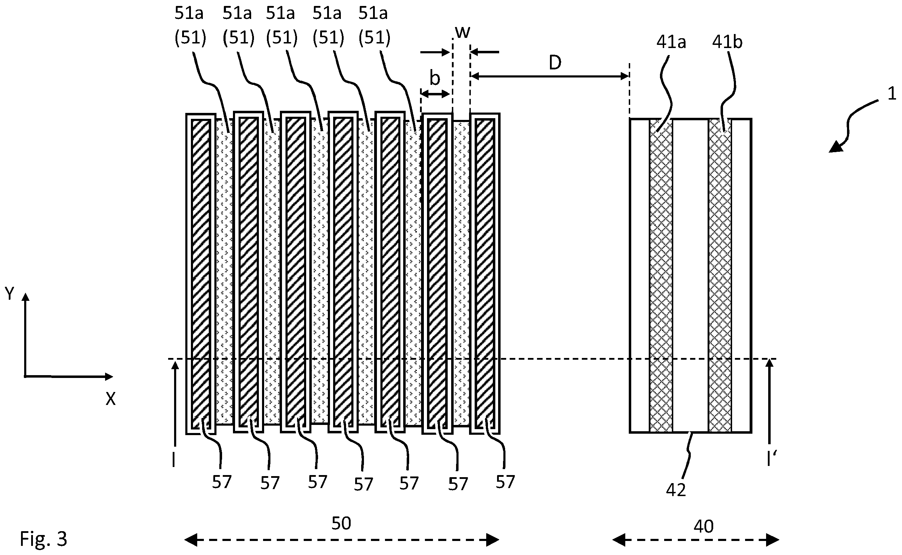

In the following, a first embodiment of the reverse conducting insulated gate power semiconductor device according to the invention is described with reference to Figs. 2 and 3. Fig. 2 shows the reverse conducting insulated gate power semiconductor device according to the first embodiment in a vertical cross section along line I-I' in Fig. 3, which shows the reverse conducting insulated gate power semiconductor device of Fig. 2 in top view.

The reverse conducting insulated gate power semiconductor device according to the first embodiment is a planar RC-IGBT 1. The RC-IGBT 1 comprises a wafer 10 having a first main side 11 and a second main side 12 opposite to the first main side 11. A first main electrode 21 is formed on the first main side 11 and a second main electrode 22 is formed on the second main side 12. The first main electrode 21 forms the emitter electrode of the RC-IGBT 1 and the second main electrode 22 forms the collector electrode of the RC-IGBT 1. The wafer 10 comprises between the first main electrode 21 and the second main electrode 22 an (n⁻)-type drift layer 31a, an (n⁺)-type buffer layer 31b, a p-type collector layer 32, at least one (n⁺)-type collector short 33, an active unit cell 40 adjacent to the first main side 11 and a pilot diode region 50. The drift layer 31a and the buffer layer 31b form an n-type first base layer 31. The collector layer 32 is in direct contact with the n-type first base layer 31 to form a first pn junction and is in direct contact with the second main electrode 22. The collector shorts 33 electrically connect the n-type first base layer 31 to the second main electrode 22.

The buffer layer 31b is arranged on the drift layer 31a towards the second main side 12 to separate the collector layer 32 from the drift layer 31a. Accordingly, the RC-IGBT 1 as shown in Figs. 2 and 3 has a punch-through (PT) configuration. The buffer layer 31b may either have a constant doping concentration profile, or may have a gradually rising doping concentration profile in a vertical direction Z towards the second main side 12. In operation of the RC-IGBT 1 at higher blocking voltages, the electric field at the interface between the drift layer 31a and buffer layer 31b will not have reached zero. Along a short distance in the buffer layer 31b it is then steeply decreased to zero due to the relatively high doping concentration thereof.

The pilot diode region 50 comprises a p-type anode layer 51 extending from the first main side 11 in the vertical direction Z to a first depth d1. The anode layer 51 comprises plural anode regions 51a that are separated from each other and alternate in a lateral first direction X parallel to the first main side 11 with trench-type first gate electrodes 57 that are respectively separated from the anode layer 51 and from the first conductivity type base layer 31 by a first gate insulating layer 56. Accordingly, each anode region 51 is laterally sandwiched between two neighbouring first gate electrodes 57. Each anode region 51a is in direct contact with the first main electrode 21 and is also in direct contact with the n-type first base layer 31 to form a second pn junction. Each first gate electrode 57 extends from the first main side 11 to a second depth d2 which is greater than the first depth d1 of the anode layer 51. Exemplarily, the first depth d1 is less than 50% of the second depth d2 and is less than 50%, more exemplarily the first depth d1 is less than one third of the second depth d2.

A lateral size w of each anode region 51 in an orthogonal projection onto a vertical plane perpendicular to the first main side 11 is equal to or less than 2 µm, exemplarily equal to or less than 1 µm, wherein a lateral direction is defined as a direction parallel to the first main side 11. The before mentioned vertical plane perpendicular to the first main side 11 is the drawing plane of Fig. 2. A distance b between each pair of neighbouring anode regions 51a is equal to or less than 2 µm, exemplarily equal to or less than 1 µm.

The active unit cell 40 comprises an n-type first source layer 41a and an n-type second source layer 41b, and a p-type second base layer 42 which is arranged on a side of the n-type first base layer 31 opposite to the collector layer 32. The n-type first base layer 31 is in direct contact with the p-type second base layer 42 to form a third pn junction and the p-type second base layer 42 is in direct contact with the first and second source layers 41a and 41b to form a fourth and a fifth pn junction, respectively. The p-type second base layer 42 is formed as a well region in the n-type first base layer 31 adjacent to the first main side 11, and the first source layer 41a and the second source layer 41b are formed as well regions in the p-type second base layer 42 adjacent to the first main side 11. Each active unit cell 40 further comprises a planar second gate electrode 47a, which is separated from the first source layer 41a, the p-type second base layer 42 and the n-type first base layer 31 by a second gate insulating layer 46a to form a first metal-insulator-semiconductor (MIS) field effect transistor (FET) structure adjacent to the first main side 11. Further, each active unit cell 40 comprises a planar third gate electrode 47b, which is separated from the second source layer 41b, the p-type second base layer 42 and the n-type first base layer 31 by a third gate insulating layer 46b to form a second planar MISFET structure adjacent to the first main side 11. The first MISFET structure and the second MISFET structure may form a double-diffused MOS (DMOS) structure at the first main side 11. A lateral distance D between the second conductivity type base layer 42 of the active unit cell 40 and the anode layer 51 in the pilot diode region 50 is at least 15 µm.

The first gate electrodes 57 are electrically insulated from the first main electrode 21 and from the second and third gate electrode 47a such that the first gate electrodes 57 are configured to be controlled independently from the second gate electrodes 47a and the first main electrode 21. Specifically, the first gate electrodes 57 are all electrically connected in common to a diode gate terminal G1. The second gate electrode 47a and the third gate electrode 47b are connected in common to a main gate terminal G2, the first main electrode is connected to an emitter terminal E and the second main electrode is connected to a collector terminal C. Therein the diode gate terminal G1 and the main gate terminal G2 may be implemented as separate contact pads on the first main side 11.

As can be seen best in the top view of Fig. 3, the first gate electrodes 57 have in an orthogonal projection onto a plane parallel to the first main side 11 a stripe-shape, a longitudinal main axis of the stripe-shape extending in a lateral second direction Y perpendicular to the lateral first direction X. Likewise, the p-type second base layer 42, the second gate electrode 47a and the third gate electrode 47b of each active unit cell 40 have in an orthogonal projection onto a plane parallel to the first main side 11 respectively a stripe-shape, a longitudinal main axis of the stripe-shape being respectively parallel to the lateral second direction Y. In Fig. 3 the lateral second direction Y is an up-down direction in the drawing plane. The longitudinal main axis of the stripe-shape is defined as that axis of the stripe-shaped element which extends along a direction in which the stripe-shape has its largest extension.

One of the first gate electrodes 57 is laterally arranged between the anode layer 51 and the second gate electrode 47a. In an exemplary embodiment any straight line connecting any first point in the p-type second base layer 42 of the active unit cell 40 with any second point in the anode layer 51 intersects this first gate electrode 57, which is laterally arranged between the anode layer 51 and the second gate electrode 47a.

On the first main side 11 of the wafer 10, an insulating layer 72 is formed continuously in a region extending from above the anode layer 51 to the p-type second base layer 42 of the adjacent active unit cell 40, so that the wafer 10 is electrically insulated from the first main electrode 21 in this area.

A control unit 200 is configured to control a diode gate emitter voltage which is defined as the electric potential of the first gate electrodes 57, i.e. at the diode gate terminal G2, minus an electric potential of the first main electrode 21, i.e. an electric potential at the emitter terminal E:
- to be positive during a time period in which the RC-IGBT 1 is in a forward conducting on-state, and
- to be negative during a time period in which the RC-IGBT 1 is in a reverse conducting state.

The control unit 200 is configured to switch the diode gate emitter voltage from a first positive value to a second negative value at least 10 µs before a turn-off event changing the RC-IGBT 1 from a forward conducting on-state to a blocking state. The control unit 200 is further configured to switch the diode gate emitter voltage from a third negative value to the fourth positive value at least 10 µs before a turn-off event changing the RC-IGBT 1 from a reverse conducting state to a blocking state.

This design allows for fault cases to have a positive main gate emitter voltage V_{GE} (which is the electric potential of the main gate terminal G2 minus the electric potential of the emitter terminal E) applied on the main gate terminal G2 and still keep the diode conduction losses low.

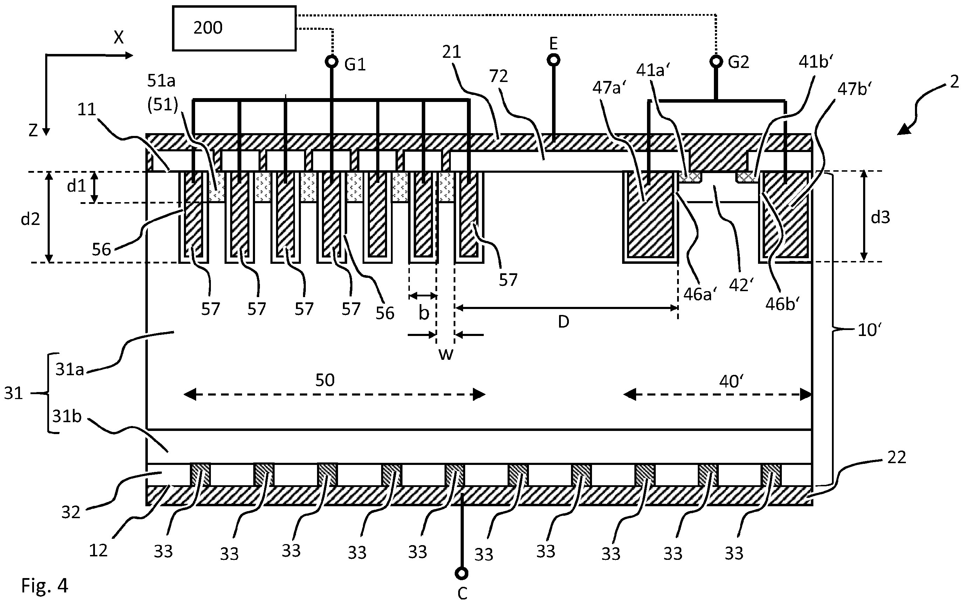

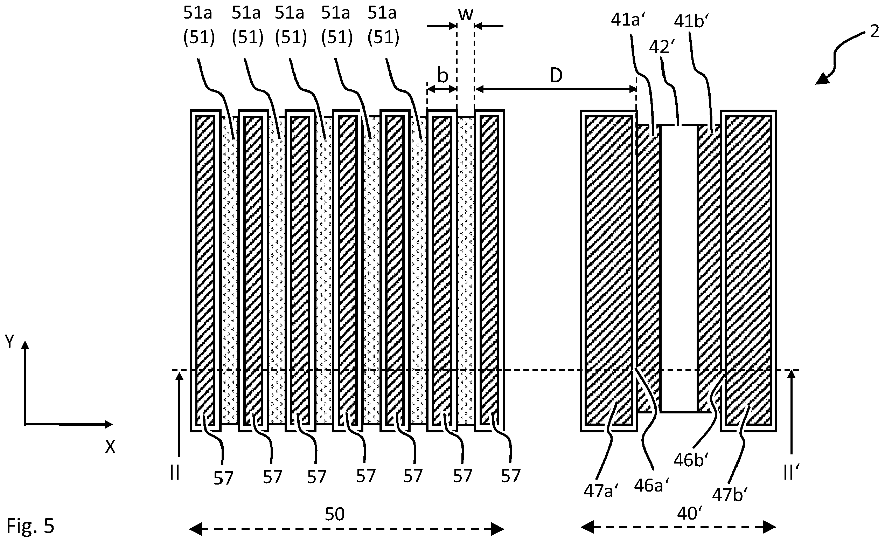

Next, a second embodiment of the reverse conducting insulated gate power semiconductor device according to the invention is discussed with reference to Figs. 4 and 5. In view of the many similarities between the first embodiment and the second embodiment, mainly differences between the first and the second embodiment will be described, whereas features which are the same for both embodiments will not necessarily be described again. Specifically, a detailed description of elements having the same reference signs will not be repeated again, but it is referred to the above description of the first embodiment. Where it is not explicitly mentioned in the following description, the second embodiment may be the same as the first embodiment.

Fig. 4 shows the reverse conducting insulated gate power semiconductor device according to the second embodiment in a vertical cross section along line II-II' in Fig. 5, which shows a top view of the reverse conducting insulated gate power semiconductor device of Fig. 4. The reverse conducting insulated power semiconductor device according to the second embodiment is a trench RC-IGBT 2. The pilot diode region 50 in the trench RC-IGBT 2 of the second embodiment has the same structure and features as the pilot diode region 50 in the first embodiment. Also, the wafer 10' has the same features regarding the drift layer 31a, the buffer layer 31b, the collector layer 32 and the collector shorts 33. However, the active unit cells 40' are trench-type active unit cells, whereas the active unit cells 40 in the first embodiment are planar active unit cells.

Each trench-type active unit cell 40' comprises an n-type first source layer 41a' and an n-type second source layer 41b', and a p-type second base layer 42' which is arranged on a side of the n-type first base layer 31 opposite to the collector layer 32. The n-type first base layer 31 is in direct contact with the p-type second base layer 42' to form a third pn junction and the p-type second base layer 42' is in direct contact with the first and second source layers 41a' and 41b' to form a fourth and a fifth pn junction, respectively. The p-type second base layer 42' is formed as a well region in the n-type first base layer 31 adjacent to the first main side 11, and the first source layer 41a and the second source layer 41b are formed as well regions in the p-type second base layer 42' adjacent to the first main side 11. Each active unit cell 40' further comprises a trench-type second gate electrode 47a', which is separated from the first source layer 41a', the p-type second base layer 42' and the n-type first base layer 31 by a second gate insulating layer 46a' to form a first vertical metal-insulator-semiconductor (MIS) field effect transistor (FET) structure adjacent to the first main side. The first vertical MISFET structure of the active unit cell 40' is a trench-type field effect transistor structure. Further, each active unit cell 40' comprises a trench-type third gate electrode 47b', which is separated from the second source layer 41b', the p-type second base layer 42' and the n-type first base layer 31 by a third gate insulating layer 46b' to form a second vertical MISFET structure adjacent to the first main side 11. The second vertical MISFET structure of the active unit cell 40' is a trench-type field effect transistor structure. The second gate electrode 47a' extends in the vertical direction Z into the wafer 10' from the first main side 11 in a first trench, the sidewalls of which are covered by the second gate insulating layer 46a'. Likewise, the third gate electrode 47b' extends in the vertical direction Z into the wafer 10' from the first main side 11 in a second trench, the sidewalls of which are covered by the third gate insulating layer 46b'. The first trench filled with the second gate insulating layer 46a' and the second gate electrode 47a' extends from the first main side 11 in the vertical direction Z into the wafer 10' to a third depth d3 as shown in Fig. 4. Likewise, the second trench filled with the third gate insulation layer 46b' and the third gate electrode 47b' extends from the first main side 11 in the vertical direction Z into the wafer 10' to the third depth d3 as shown in Fig. 4. In the active unit cell 40' the second base layer 42', the first source layer 41a' and the second source layer 41b' are laterally sandwiched or interposed between the second gate electrode 47a' and the third gate electrode 47b'.

In the exemplary embodiment shown in Fig. 4, the second depth d2, and the third depth d3 are the same. However, the third depth d3 may be smaller than the second depth d2. Also, the first and second trenches may extend to different depths into the wafer 10'.

In the RC-IGBT 2, laterally between each pilot diode region 50 and the second conductivity type base layer 42' of the active unit cell 40', there is arranged the first second gate electrode 47a' of the active unit cell 40'.

As shown in Fig. 5 the second gate electrode 47a', the third gate electrode 47b' and the p-type second base layer 42' of the active unit cell 40' have in an orthogonal projection onto a plane parallel to the first main side 11 a stripe-shape, a longitudinal main axis of which is parallel to the lateral second direction Y.

Similar to the first embodiment, an insulating layer 72 is formed continuously in a region extending, in an orthogonal projection onto a plane parallel to the first main side 11, in an area between the anode layer 51 and the p-type second base layer 42' of the active unit cell 40', so that the wafer 10' is electrically insulated from the first main electrode 21 in this area.

The second gate electrode 47a' of the active unit cell 40' is laterally arranged between the anode layer 51 and the second conductivity type base layer 42' of the active unit cell 40'.

The control unit 200 in the second embodiment provides the same control as the control unit 200 in the first embodiment. In the trench RC-IGBT 2 such control of the control unit 200 can in addition prevent degradation of the gate insulation layers 46a' and 46b' during turn-off due to hole extraction in the diode area.

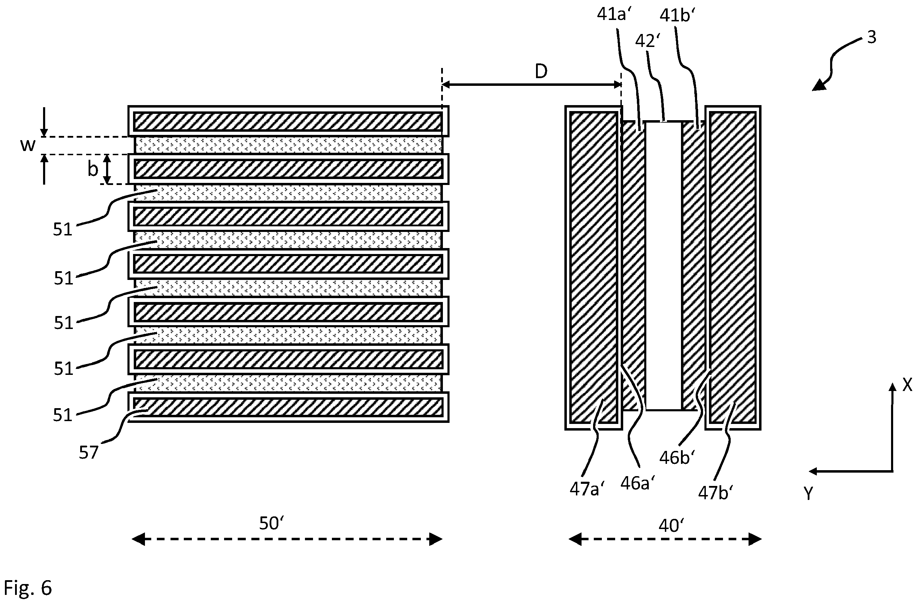

In Fig. 6 there is shown a reverse conducting insulated gate power semiconductor device according to a third embodiment in top view. The reverse conducting insulated gate power semiconductor device according to the third embodiment is a trench-type RC-IGBT 3 which differs from the RC-IGBT 2 only in that the stripe-shaped first gate electrodes 57 and the stripe-shaped anode regions 51a of the pilot diode region 50' have a different orientation relative to the stripe-shaped second gate electrode 47a' and the stripe-shaped third gate electrode 47b' of the active unit cell 40'. Instead of being arranged with its main axes parallel to the stripe-shaped second gate electrode 47a' and the stripe-shaped third gate electrode 47b' of the active unit cell 40' as in the second embodiment, the stripe-shaped first gate electrodes 57 and stripe-shaped anode regions 51a of the pilot diode region 50' are oriented perpendicular to the stripe-shaped second gate electrode 47a' and the stripe-shaped third gate electrode 47b' of the active unit cell 40'. Otherwise the structure of the RC-IGBT 3 is similar to the above described RC-IGBT 2. In particular, the structure of the pilot diode region 50' is the same as the structure of the pilot diode region 50 in the first and second embodiment. The structure of the active unit cell 40' is the same as in the above described second embodiment. Like in the above embodiments, a minimum distance D' between the anode layer 51 to the p-type second base layer 42' of the active unit cell 40' is at least 15 µm.

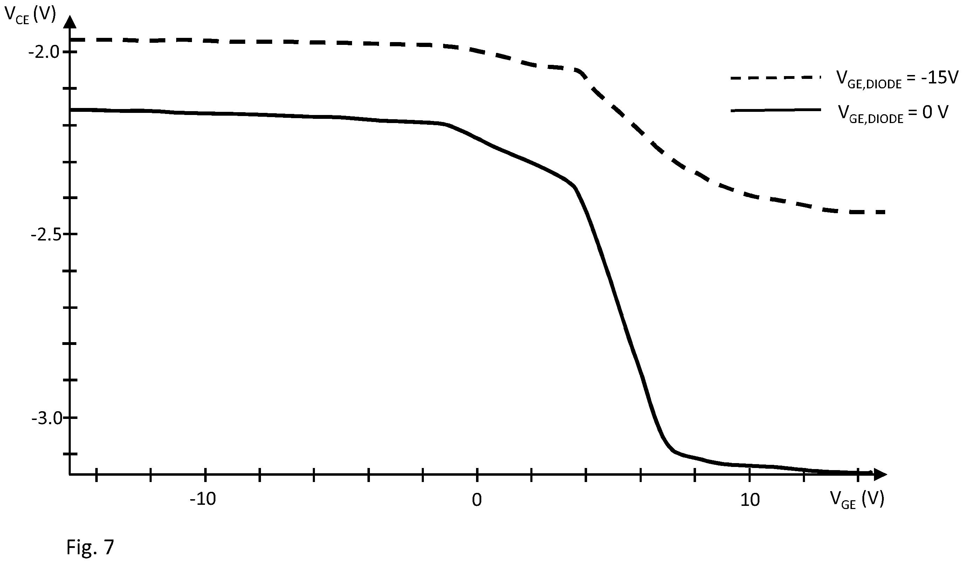

FIG. 7 shows a comparison of the diode on-state (i.e. reverse conducting or diode mode) during the switching event from a main gate emitter voltage V_{GE} = -15V to V_{GE} = +15V in the RC-IGBT 2 for two different diode gate emitter voltages V_{GE,DIODE} = -15 V and V_{GE,DIODE} = 0 V, wherein the main gate emitter voltage V_{GE} is a voltage applied between the main gate terminal G2 and the emitter terminal E (that means that V_{GE} corresponds to the electric potential of the main gate terminal G2 minus the electric potential of the emitter terminal E), and wherein the diode gate emitter voltage V_{GE,DIODE} is a voltage applied between the diode gate terminal G1 and the emitter terminal E (that means that V_{GE,DIODE} corresponds to the electric potential of the diode gate terminal G1 minus the electric potential of emitter terminal E). The dashed line in FIG. 7 illustrates the collector emitter voltage V_{CE} across the device for V_{GE,DIODE} = -15 V and the bold line illustrates the collector emitter voltage V_{CE} across the device for V_{GE,DIODE} =0 V. It can be seen in Fig. 6 that the collector emitter voltage V_{CE} is negative, which means that the RC-IGBT 2 is biased in reverse direction (i.e. it is in a reverse conducting mode). As can also be seen from Fig. 6 that the absolute voltage drop across the device (i.e. |V_{CE}|) increases when switching the main gate emitter voltage V_{GE} applied to the main gate terminal G2 from V_{GE} = -15V to V_{GE} = +15V, i.e. when switching from a negative potential at the second and third gate electrodes 47a' and 47b' to a positive potential at the second and third gate electrodes 47a' and 47b'. This can be explained by short-circuiting the source regions 41a' and 41b' with the n-type base layer 31 by forming a conductive channel between the source regions 41a' and 41b' and the n-type base layer 31. The absolute voltage drop |V_{CE}| across the RC-IGBT 2 in reverse conducting mode (diode mode) is significantly lower when a negative diode gate emitter voltage V_{GE,DIODE} = -15 V is applied between the diode gate terminal G2 and the emitter terminal E compared to the situation when the diode gate terminal G2 is held at the same electric potential as the emitter terminal E. Accordingly, it can be seen that losses in diode mode can be lowered in the RC-IGBT 2 by applying a negative diode gate emitter voltage V_{GE,DIODE} = -15 V between the diode gate terminal G2 and the emitter terminal E. For optimizing the conduction losses in the reverse conducting state, i.e. in the diode mode, the control unit 200 may be configured to apply a negative diode gate emitter voltage V_{GE,DIODE} during a time period in which the RC-IGBT 2 is in the reverse conducting state as described above. The same applies for the planar RC-IGBT 1 and the trench RC-IGBT 3 described above.

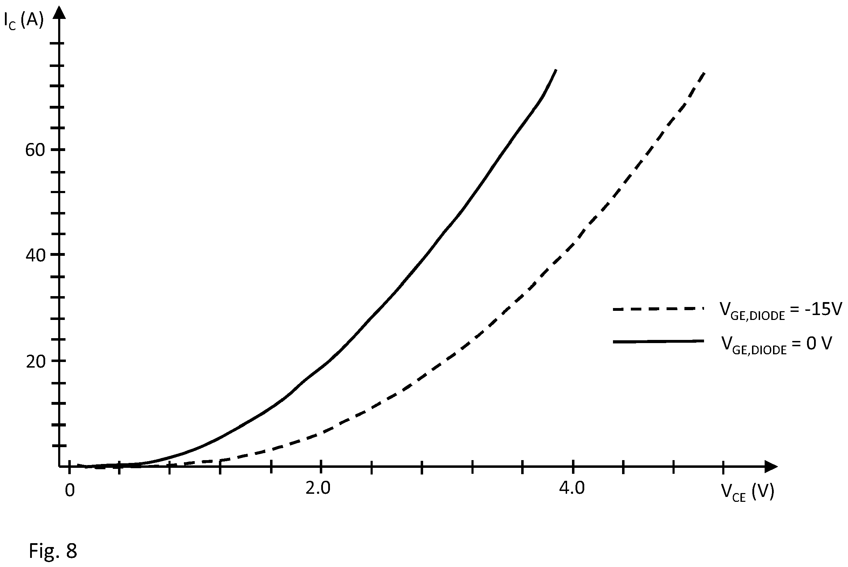

FIG. 8 shows a graph of the collector current I_{C} versus the collector emitter voltage V_{CE} applied between the emitter terminal E and the collector terminal C (i.e. between the first main electrode 21 and the second main electrode 22) in the RC-IGBT 2 in IGBT mode for two different diode gate emitter voltages V_{GE,DIODE} = -15 V and V_{GE,DIODE} = 0 V. The conduction losses are lower for V_{GE,DIODE} = 0 V. In IGBT mode the conduction losses are relatively high when applying a negative diode gate emitter voltage V_{GE,DIODE} = -15 V between the diode gate terminal G2 and the emitter terminal E. For optimizing the conduction losses in the forward on-state, i.e. in the IGBT mode, the control unit 200 may be configured to apply a positive diode gate emitter voltage V_{GE,DIODE} during a time period in which the RC-IGBT 2 is in the forward conducting on-state as described above. The same applies for the planar RC-IGBT 1 and the trench RC-IGBT 3 described above.

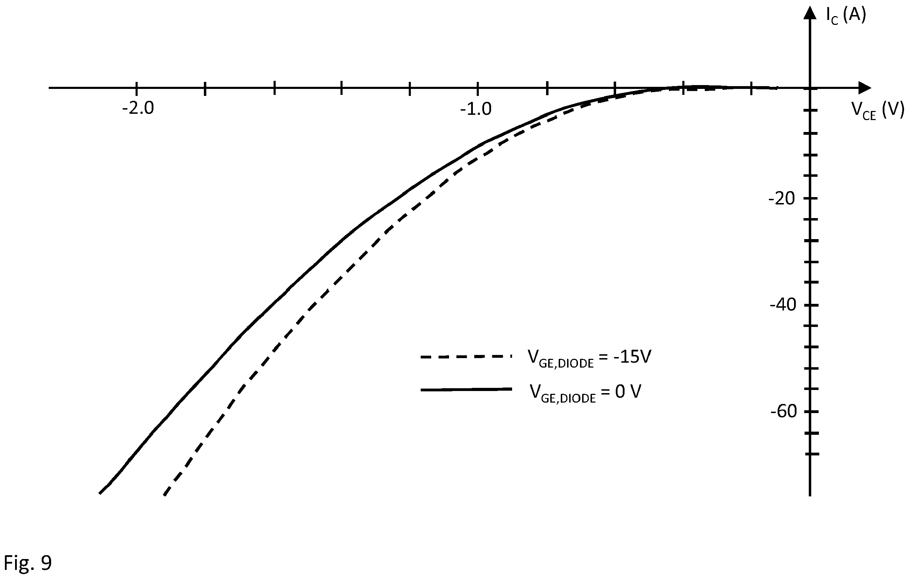

FIG. 9 shows a graph of the collector current I_{C} versus the collector emitter voltage V_{CE} applied between the emitter terminal E and the collector terminal C (i.e. between the first main electrode 21 and the second main electrode 22) in the RC-IGBT 2 in diode mode for two different diode gate emitter voltages V_{GE,DIODE} = -15 V and V_{GE,DIODE} = 0 V. The conduction losses are lower for V_{GE,DIODE} = -15 V. Accordingly, in diode mode the conduction losses are relatively high when applying a positive diode gate emitter voltage V_{GE,DIODE} between the diode gate terminal G2 and the emitter terminal E. For optimizing the conduction losses in the reverse conducting state, i.e. in the diode mode, the control unit 200 may be configured to apply a negative diode gate emitter voltage V_{GE,DIODE} during a time period in which the RC-IGBT 2 is in the reverse conducting state as described above. The same applies for the planar RC-IGBT 1 and the trench RC-IGBT 3 described above.

It will be appreciated by those skilled in the art that the present invention can be embodied in other specific forms without departing from the scope of the invention as defined by the appended claims.

For example in the above embodiments the reverse conducting insulated gate power semiconductor device was described with one pilot diode region 50, 50' and one active unit cell 40, 40'. However, the reverse conducting insulated gate power semiconductor device of the invention may comprise plural pilot diode regions 50, 50. Also, it may include plural active unit cells 40, 40'. The plural active unit cells 40, 40' may be arranged in groups of directly adjacent active unit cells 40, 40'. The groups of plural active unit cells 40, 40' may alternate with plural pilot diode regions 50, 50' in a lateral direction. In case that plural pilot diode regions 50, 50' each have stripe-shaped first gate electrodes 57 and stripe-shaped anode regions 51a of the plural pilot diode regions 50, 50' then the orientation in the plural pilot diode regions 50, 50' may different from each other, i.e. in one of the plural pilot diode regions 50, 50' the main axes of the stripe shaped first gate electrodes 57 may extend along a first lateral direction while the main axes of the stripe shaped first gate electrodes 57 may extend along a second lateral direction different from the first lateral direction. Likewise main axis orientations of plural stripe-shaped active unit cells may differ from each other.

While the above described reverse conducting insulated gate power semiconductor devices are punch-trough (PT) RC-IGBTs 1, 2 or 3 with a buffer layer 31b, the reverse conducting insulated gate power semiconductor device of the invention may also be a non-punch through (NPT) device without any buffer layer 31b.

In the above embodiments the cell structure of the active unit cell 40, 40' was described to be a stripe-shaped cell structure, i.e. with stripe-shaped second gate electrode 47a, 47a', stripe-shaped third gate electrode 47b, 47b', stripe-shaped p-type second base layer 42, 42'. However in the reverse conducting insulated gate power semiconductor device the invention the active unit cells 40, 40' may also have any other shape in orthogonal projection onto a plane parallel to the first main side 11 such as a hexagonal shape or a polygonal shape. For example, other designs for the second gate electrode 47a, 47a', stripe-shaped third gate electrode 47b, 47b', stripe-shaped p-type second base layer 42, 42' are also possible like square design, circular design, ring design, hexagonal design, etc. Likewise, while in the above embodiments the pilot diode region 50, 50' was described to have in, an orthogonal projection onto a plane parallel to the first main side 11, stripe-shaped first gate electrodes 57 and stripe-shaped anode regions 51a, the first gate electrodes 57 and the anode regions 51a of the pilot diode region 50, 50' may also have any other shape in orthogonal projection onto a plane parallel to the first main side 11 such as a hexagonal shape or a polygonal shape.

In the above embodiments the reverse conducting insulated gate power semiconductor device of the invention was described to be an RC-IGBT 1, 2, 3. However, the reverse conducting insulated gate power semiconductor device of the invention may be also another semiconductor device such as a bi-mode insulated gate transistor (BIGT). In an RC-IGBT, at the collector side, alternating n+ doped areas are introduced into an IGBT p⁺ anode layer, which then act as a cathode contact for the internal diode mode of operation. The area ratio between the IGBT anode (p⁺ regions) and the diode cathode (n+ regions) determines which part of the collector area is available in IGBT or diode modes, respectively. During the RC-IGBT conduction in diode mode, the p⁺ regions are in-active and do not directly influence the diode conduction performance. However on the other hand, the n+ regions act as anode shorts in the IGBT mode of operation, strongly influencing IGBT conduction mode. One of the implications of anode shorting is the voltage snapback referred to previously which is observed as a negative resistance region in the device IGBT mode I-V characteristics. This effect will have a negative impact when devices are paralleled, especially at low temperature conditions. To resolve this issue, a second integration step is done in the BIGT concept. It has been shown that the initial snap-back in an RC-IGBT can be controlled and eliminated by introducing wide p+ regions into the device, also referred to as a pilot-IGBT. This approach resulted in the BIGT concept which in principle a hybrid structure consisting of an RC-IGBT and a standard IGBT in a single chip. In the BIGT the pilot area may be centralized in the middle to obtain better thermal distributions and reduced current non-uniformities and may also be designed to provide the outermost reach within the chip while ensuring a large RC-IGBT region. A striped structure may deployed for the alternating p+ and n+ regions with an optimized radial layout to ensure smooth and fast transition in the IGBT conduction mode from the pilot area to rest of the chip.

The above described RC-IGBTs 1, 2, 3 may include further features such as an enhancement layer, which is a layer having the same conductivity type as the drift layer 31a but which has a higher doping concentration. The enhancement layer may be arranged between the drift layer 31a and the second base layer 42, 42'. There may also be arranged an additional p-type region in a trench-type RC-IGBT in the drift layer for example at the bottom side of the trench-type gate electrode for protecting the trench-type gate electrodes against high electric fields.

In all embodiments, the conductivity types may be switched, i.e. in an alternative embodiment all layers within one specific embodiment which are described above as n-type are all p-type and all layers which are described above to be p-type are n-type.

It should be noted the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

### List of reference signs

- 1, 150: (planar) RC-IGBT
- 2, 3: (trench) RC-IGBT
- 10, 10', 100: wafer
- 11, 111: first main side
- 12, 112: second main side
- 21, 121: first main electrode
- 22, 122: second main electrode
- 31: n-type (first) base layer
- 31a, 131a: drift layer
- 31b, 131b: buffer layer
- 32, 132: collector layer
- 33, 133: collector short
- 40, 40': active unit cell
- 41a, 41a': first source layer
- 41b, 41b': second source layer
- 42, 42', 142: p-type (second) base layer
- 46a, 46a': second gate insulating layer
- 46b, 46b': third gate insulating layer
- 47a, 47a': second gate electrode
- 47b, 47b': third gate electrode
- 50, 50': pilot diode region
- 51: anode layer
- 51a: anode region
- 56: first gate insulating layer
- 57: first gate electrode
- 72: insulating layer
- 141: n-type source region
- 146: gate insulating layer
- 147: (planar) gate electrode
- 149: insulating layer
- 200: control unit
- d1: first depth
- d2: second depth
- d3: third depth
- C: collector terminal
- D: lateral distance
- E: emitter terminal
- G1: diode gate terminal
- G2: main gate terminal
- I_{C}: collector current
- X: first direction
- Z: second direction
- V_{CE}: collector emitter voltage
- V_{GE}: (main) gate emitter voltage
- V_{GE,DIODE}: diode gate emitter voltage
- w: lateral size

## Claims

1. A reverse conducting insulated gate power semiconductor device comprising a wafer (10; 10') having a first main side (11) and a second main side (12) opposite to the first main side (11), a first main electrode (21) on the first main side (11) and a second main electrode (22) on the second main side (12), wherein the wafer (10; 10') comprises:
a first conductivity type base layer (31);
a second conductivity type collector layer (32) which is in direct contact with the first conductivity type base layer (31) to form a first pn junction and
which is in direct contact with the second main electrode (22), wherein the second conductivity type is different from the first conductivity type;
at least one collector short (33) which electrically connects the first conductivity type base layer (31) to the second main electrode (22);
an active unit cell (40; 40') adjacent to the first main side (11); and
a pilot diode region (50; 50') comprising a second conductivity type anode layer (51) extending from the first main side (11) to a first depth (d1),
wherein the anode layer (51) comprises plural anode regions (51a) that are separated from each other and alternate in a lateral first direction (X) parallel to the first main side (11) with trench-type first gate electrodes (57) that are respectively separated from the anode layer (51) and from the first conductivity type base layer (31) by a first gate insulating layer (56),
wherein each anode region (51a) is in direct contact with the first main electrode (21) and is in direct contact with the first conductivity type base layer (31) to form a second pn junction, and
wherein the active unit cell (40; 40') comprises:
a first conductivity type first source layer (41a; 41a'), which is in direct contact with the first main electrode (21) on the first main side (11);
a second conductivity type base layer (42; 42') on a side of the first conductivity type base layer (31) opposite to the collector layer (32),
wherein the first conductivity type base layer (31) is in direct contact with the second conductivity type base layer (42; 42') to form a third pn junction and wherein the second conductivity type base layer (42; 42') is in direct contact with the first source layer (41a; 41a') to form a fourth pn junction; and
a second gate electrode (47a; 47a'), which is separated from the first source layer (41a; 41a'), the second conductivity type base layer (42; 42') and the first conductivity type base layer (31) by a second gate insulating layer (46a; 46a') to form a first field effect transistor structure,
**characterized in that** the first gate electrodes (57) are electrically insulated from the first main electrode (21) and from the second gate electrode (47a, 47a') such that the first gate electrodes (57) are configured to be controlled independently from the second gate electrodes (47a, 47a') and the first main electrode (21).

2. The reverse conducting insulated gate power semiconductor device according to claim 1, wherein a lateral size (w) of each anode region (51a) in an orthogonal projection onto a vertical plane perpendicular to the first main side (11) and parallel to the lateral first direction (X) is equal to or less than 2 µm, or is equal to or less than 1 µm.

3. The reverse conducting insulated gate power semiconductor device according to claim 1 or 2, wherein a distance (b) between each pair of neighbouring anode regions (51a) is equal to or less than 2 µm, or is equal to or less than 1 µm.

4. The reverse conducting insulated gate power semiconductor device according to any one of claims 1 to 3, wherein each first gate electrode (57) extends from the first main side (11) to a second depth (d2) which is greater than the first depth (d1) of the anode layer (51).

5. The reverse conducting insulated gate power semiconductor device according to any one of claims 1 to 4, wherein a lateral distance (D) between the second conductivity type base layer (42; 42') of the active unit cell (40; 40) and the anode layer (51) is at least 15 µm.

6. The reverse conducting insulated gate power semiconductor device according to any one of claims 1 to 5, wherein the first gate electrodes (57) are all electrically connected in common to a diode gate terminal (G1).

7. The reverse conducting insulated gate power semiconductor device according to any one of claims 1 to 6, wherein the first field effect transistor structure of the active unit cell (40') is a trench-type field effect transistor structure in which the second gate electrode (47a') is structured as a trench-type gate electrode that extends from the first main side (11) in a second direction (Z) towards the second main side (12).

8. The reverse conducting insulated gate power semiconductor device according to claim 7, wherein the second gate electrode (47a') of the active unit cell (40') is laterally arranged between the anode layer (51) and the second conductivity type base layer (42') of the active unit cell (40').

9. The reverse conducting insulated gate power semiconductor device according to any one of claims 1 to 8, wherein the active unit cell (40') comprises:
a first conductivity type second source layer (41b'), which is in direct contact with the first main electrode (21) on the first main side (11) and which is in direct contact with the second conductivity type base layer (42') to form a fifth pn junction; and
a third gate electrode (47b'), which is separated from the second source layer (41b'), the second conductivity type base layer (42') and the first conductivity type base layer (31) by a third gate insulating layer (46b') to form a second field effect transistor structure in the active unit cell (40'),
wherein the second and the third gate electrodes (47a', 47b') of the active unit cell (40') are trench-type gate electrodes between which the second conductivity type base layer (42') and the first and second source layers (41a', 41b') are laterally interposed.

10. The reverse conducting insulated gate power semiconductor device according to any one of claims 1 to 9, wherein the reverse conducting insulated gate power semiconductor device is a reverse conducting insulated gate bipolar transistor (1; 2; 3) or a bi-mode insulated gate transistor.

11. The reverse conducting insulated gate power semiconductor device according to any one of claims 1 to 10, wherein the first gate electrodes (57) have in an orthogonal projection onto a plane parallel to the first main side (11) a stripe-shape, a longitudinal main axis of the stripe-shape extending perpendicular to the lateral first direction (X).

12. The reverse conducting insulated gate power semiconductor device according to any one of claims 1 to 11, wherein one of the first gate electrodes (57) is laterally arranged between the anode layer (51) and the second gate electrode (47a; 47a').

13. A system comprising the reverse conducting insulated gate power semiconductor device according to any one of the preceding claims and a control unit (200), wherein the control unit (200) is configured to control a diode gate emitter voltage which is defined as the electric potential of the first gate electrodes (57) minus an electric potential of the first main electrode (21):
- to be positive during a time period in which the reverse conducting insulated gate power semiconductor device (1; 2; 3) is in a forward conducting on-state, and
- to be negative during a time period in which the reverse conducting insulated gate power semiconductor device (1; 2; 3) is in a reverse conducting state.

14. The system according to claim 13, wherein the control unit (200) is configured to switch the diode gate emitter voltage from a first positive value to a second negative value at least 10 µs before a turn-off event changing the reverse conducting insulated gate power semiconductor device (1; 2; 3) from a forward conducting on-state to a blocking state.

15. The system according to claim 13 or 14, wherein the control unit (200) is configured to switch the diode gate emitter voltage from a third negative value to a fourth positive value at least 10 µs before a turn-off event changing the reverse conducting insulated gate power semiconductor device (1; 2; 3) from a reverse conducting state to a blocking state.
